(19) Europäisches Patentamt
European Patent Office
Office européen des brevets

(11) **EP 1 887 687 A1**

(12) **EUROPEAN PATENT APPLICATION**

(43) Date of publication:
**13.02.2008 Bulletin 2008/07**

(51) Int Cl.:
*H03G 5/24* (2006.01)   *H04R 3/04* (2006.01)

(21) Application number: **06016049.6**

(22) Date of filing: **01.08.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Vestel Elektronik Sanayi ve Ticaret A.S. 45030 Manisa (TR)**

(72) Inventor: **Ecder, Halit Kaan Organize Sanayi Bölgesi 45030 Manisa (TR)**

(74) Representative: **HOFFMANN EITLE Patent- und Rechtsanwälte Arabellastrasse 4 81925 München (DE)**

(54) **Compensating device and method for acoustical systems**

(57)     Device for frequency response characteristics compensation of acoustical systems, which comprises at least one sound output device 10; a frequency generator 35 for generating a plurality of test signals of different effective test frequencies to be applied to the sound output device 10; an impedance measuring device 20 connected to the sound output device 10 for determining the impedance of the sound output device 10 for each of the plurality of test signals applied to the sound output device 10; and a memory unit 33 for storing frequency response characteristics compensation information for each test frequency, in accordance with the impedance determined for the test signal of each test frequency. Furthermore, a sound processing device 30 for generating acoustical signals to be output to the sound output device 10, based on input signals, which are power-compensated according to their respective frequency components and said compensation information, to thereby compensate for differences in the impedance of said sound output device 10 at different output frequencies. The invention also comprises a method, in which, based on the impedance for test signals, a frequency response characteristics compensation information for each frequency of the test signals is determined; and a frequency response characteristics compensation information for all frequencies is stored into a memory unit; which stored information will be used by a sound processing device for frequency response characteristics compensation of an acoustical system comprising the sound output device.

FIG. 1

EP 1 887 687 A1

**Description**

The present invention is directed to a device and methods for frequency response characteristics compensation of acoustical systems by determined frequency dependent impedances.

In particular, the present invention relates to a method and device for power compensation for acoustical systems by using impedance information of the system, thereby establishing high fidelity sound, solving safety problems for the system, providing dynamic speaker compensation, etc. This method can be applicable on every multimedia consumer and professional grade electronic product which uses a sound output device.

The main problem for acoustical systems is the frequency response characteristics of sound output devices because sound output devices do not have the same characteristics for every frequency. The changing impedance in the system causes imparted sound quality, unreliability and safety problems. Compensation must be established to get over these problems.

One of the main parameters in sound quality of multimedia devices - like audio reproduction systems - is the frequency response characteristics. A person can, depending on age, realize an audio frequency range between 20 Hz and 22 kHz. Thus, a sound reproduction device is expected to provide this frequency range.

The assessment of this performance criterion is made by acustical test devices and an analysis in the frequency domain, as shown below. The efficiency of the audio device is accepted to be the frequency range. The SPL (sound pressure level) is used to determine this range. A $\pm$ 3 dB change in the SPL is accepted to be the limits of the working frequency range (Some standards take these values as $\pm$ 5 dB). These frequencies are the high cut-off frequency and the low cut-off frequencies of the system. Acoustical compensation is the process for fixing the cut-off frequencies of the devices.

Frequency based acoustical performance improvements are generally achieved by bandpass filters on sound processors or analogue bandpass filters (equalizers) where the system does not include sound processors and/or general purpose processors.

There are many applicable methods for this operation of amplitude modification. The result of this modification is observed at the output power. Frequency based output power is established at the output of the amplifier.

There are many reasons for not obtaining a straight frequency response characteristic in the acoustical test. A non ideal impedance & frequency characteristic of the speaker is one of these reasons.

The impedance of the speaker changes with the frequency. As the speaker behaves like a resistance, the speaker generally needs to be driven by a changeable current to have a stable power for every frequency.

In addition, the frequency response characteristics of the speaker changes with the acoustical structure of the system. So, upon modifying the system, it needs to be tested again as it will have a different frequency response characteristic.

To establish a straight SPL (sound pressure level) performance curve;

• The difference of impedance caused by the interaction of the cabinet and the speaker,
• The variable impedance values caused by the difference in speaker configurations (2 way - 3 way) and related crossover network system,
• The difference caused by production (deviations in assembling the sound output device or deviations in the production of the sound output device), and
• The variations of the impedance of the amplifier with the frequency

should be considered and impedance compensation should be applied.

There are two main methods known for providing a stable power at the output: controlling the voltage at the output and compensating the impedance at the output:

• Equalizers are used to control the amplitude of the audio signals. This provides voltage control at the output.
• RLC circuits are used to control the output impedance.

Equalizers operate at certain frequencies. That means, it is not possible to totally control the frequency domain as equalizers do not include a filter for every frequency. As mentioned above, characteristics of each sound output device are unique and for best performance, the exact frequency should be compensated. Also, the compensation is made by considering the processed output signal. That means, there is no control of the output device. This may cause safety problem as the current through the output device is not controlled.

RLC circuits provide impedance compensation at the output device for certain frequencies. They are designed for the general frequency response of that sound output device type. They cannot be redesigned for every system throughout manufacturing. Also the difference between the impedances of a sound output device can attain high values. In that situation an RLC circuit may not be capable of compensating the impedance of the output.

Every sound output device has a unique frequency response characteristic. Any difference that may be caused due to the tolerance of the elements used in the manufacturing of the device or the assembling of the sound output device causes the frequency response to change. So, every sound system has to be tested and adjusted for the best performance individually. It is not applicable to serial production of most of the products.

Compensation methods that are conducted by using the audio output signal are not capable of considering the characteristics of the sound output devices. That means, the compensation is done, due to the output signal. Audio signals cannot be effected if the output device has high impedance values in that frequency. I.e., some sound output devices cannot correctly output the audio data as an. This causes degradation in audio quality at the frequency concerned. Also the harmonics of that signal can be responsible for generating noise at other frequencies. In other words, those systems are not capable of controlling the noise that is caused by the structure of the output device.

Equalizers have certain frequency compensation limits and cannot be calibrated perfectly for every sound output device.

The differences between the impedance values of some sound output devices at some frequencies are so great that they can not be compensated with RLC circuits.

Accordingly, it is the object of the present invention to provide an approach for a better compensation of impedance variations in sound output devices than previously available with equalizers and RLC circuits.

This object is solved by the provision of a device, a method for determining compensation information, a method for operating a sound device, and a method for manufacturing a sound device, according to the independent claims. Further features, advantages and aspects of the invention will be understood in connection with the dependent claims, the description and the attached drawings.

The basic principle of the invention resides in the provision of a mechanism which compensates frequency components of an input signal in a way that the different impedances the output device (speaker, headphone) exhibits at these frequencies, are "levelled" or compensated.

Accordingly, the invention is in a first aspect directed to a device for frequency response characteristics compensation of acoustical systems which comprises at least one sound output device; a frequency generator for generating a plurality of test signals of different effective test frequencies to be applied to the sound output device; an impedance measuring device connected to the sound output device for determining the impedance of the sound output device for each of the plurality of test signals applied to the sound output device; a memory unit for storing frequency response characteristics compensation information for each test frequency, in accordance with the impedance determined for the test signal of each test frequency; and a sound processing device for generating acoustical signals to be output to the sound output device, based on input signals, which are power-compensated according to their respective frequency components and said compensation information, to thereby compensate for differences in the impedance of said sound output device at different output frequencies.

Preferably, the device according to the invention further comprises an amplifier coupled between the sound processing device and the sound output device for amplifying the acoustical signal. This amplifier may e.g. be employed if a speaker or speaker system is to be driven by the output of the device.

Preferably, the sound processing device is configured to adjust input signal components of different frequencies having equal input power so as to generate acoustical signals resulting in equal power for the respective frequencies at the sound output device. The power may be the electrical power in the sound output device, or the sound pressure level of the device, etc.

The device may further be characterised in that the frequency generator is connected to the sound processing device, for outputting the test signals to the sound output device via the sound processing device. This has the advantage that the same processing that is applied to the audio signals may also be applied to the test signal, thus better mimicking the behaviour of the overall device.

In a preferred embodiment, the device further comprises a calculating unit connected to the impedance measuring device and to the memory unit, which is used for determining the compensation information according to the measured impedance and a preset algorithm, or/and for calculating the impedance from other values obtained by the impedance measuring device, and for storing said compensation information in the memory unit.

As described above, the sound processing device may perform the two tasks of performing a power compensation of the input signal, and of performing further processing known in the art of sound processing, like e.g. filtering, amplitude adjustment or frequency push up/down. In a preferred embodiment of the invention, the sound processing device may comprise a sound processor for performing these tasks of adjusting electrical characteristics of the input signals according to preset rules, and of compensating for differences in the impedance of said sound output device at different output frequencies, according to said compensation information. A sound processor is an "off the shelf" product which has the advantage of being cheap and well known to programmers. Often, there are standard programs for performing some of the basic tasks of sound processing, which may be used in the present invention.

Some sound processors comprise frequency generators. Accordingly, in one preferred embodiment of the invention, the frequency generator may be a part of the sound processor. The integration of the two functions allows for a smoother integration and will lower production cost.

Further, the sound processor may also comprise prescale blocks configured for said compensation of the input signals for said differences in the impedance of said sound output device at different output frequencies, according to said compensation information, and common compensation blocks arranged after the prescale blocks configured for adjusting said electrical characteristics of the input signals according to the preset rules.

In a further preferred embodiment of the invention, the sound processing device comprises a microprocessor for compensating the input signals for said differences in the impedance of said sound output device at different output frequencies, according to said compensation information, a sound processor for adjusting electrical characteristics of the input signals compensated at the microprocessor, according to preset rules, and a connection between the microprocessor and the sound processor for supplying the input signal to the microprocessor and for supplying the compensated input signals back to the sound processor.

Alternatively, in a further preferred embodiment, the sound processing device may comprise a microprocessor or a microcontroller for calculating compensation instructions for compensating differences in the impedance of said sound output device at different output frequencies, according to said compensation information, a connection between the microprocessor and a sound processor and said sound processor for adjusting electrical characteristics of the input signals according to preset rules, and for compensating said differences in the impedance of said sound output device at different output frequencies, according to said compensation instructions received via the connection.

The microprocessor or microcontroller (in the following, as well as the claims, the term microprocessor will be used as comprising microprocessors as well as microcontrollers. It is to be understood that a microcontroller comprises a microprocessor and additional components, like e.g. memory, input/output ports, further controllers for hardware devices etc.) may at the same time also take the function of the above-mentioned calculating unit which is connected to the impedance measuring device and to the memory unit, for determining said compensation information according to the measured impedance and a preset algorithm, and for storing said compensation information in the memory unit.

The memory unit may be part of the microprocessor, or the signal processor, or may be a separate device.

As already outlined above, the sound output device may be any of a number of known devices for generating sound waves. The sound output device may for example comprise a headphone or a speaker or a set of speakers.

The compensation information determined/calculated may take several kinds. For example, the compensation information may preferably be the determined impedance for each frequency, or may be a correction factor for the determined impedance for each frequency. Storing the impedances as such requires less calculation when the measurements are performed, but will require more real time calculations when the compensation is done while operating the sound device. Conversely, using a correction factor will require more calculations when the impedance is measured, but may simplify the determination of the compensation to be performed on an input signal in operating the device.

The quality of the compensation according to the present invention will inter alia be determined by the number and location in the frequency spectrum of the analysed frequencies. The minimum number of frequencies, for which impedances are determined, will be two. The more frequencies are measured and compensated, the better should be the result of the power compensation; but the more measurements and calculations are required.

In one preferred embodiment, the plurality of test signals have equally spaced frequencies. Alternatively, the plurality of test signals have predetermined frequencies.

The test signals may take any suitable signal shape. In one preferred embodiment, the test signals are sinoidal signals.

Preferably, there is some kind of synchronisation between the frequency generator and the remaining parts of the measuring system, in order to assure that the impedance measurements are correlated and stored with the right one of the frequencies.

The invention is in another aspect directed to methods. Everything that was said with regard to the device does likewise apply to the methods and vice versa, so that mutual reference is made.

One aspect of the invention is a method for performing frequency response characteristics compensation of acoustical systems, and comprises the steps:

- Successively applying test signals of a plurality of different effective test frequencies to at least one sound output device;

- Determining for each test signal applied an impedance of the sound output device;

- Determining, based on the impedance for each test signal, a frequency response characteristics compensation information for each frequency; and

- storing the frequency response characteristics compensation information for all frequencies; which is to be used by a sound processing device for power compensation of differences in the impedance of said sound output device at different output frequencies, of an acoustical system comprising the sound output device, into a memory unit.

Performing this inventive method allows for a "calibration" of a sound device, in order to achieve optimised sound output characteristics.

The method is preferably performed when the sound output device is first operated after its manufacturing. This will set the required compensation values for each individual sound output device, in order to compensate individual differences of such devices caused by manufacturing deviations.

In order to account for changes in the frequency response characteristics which may occur over time due to aging effects of the sound output device, the method is in another preferred embodiment performed each time the sound output device is initialised. The method may also be performed periodically or manually.

Preferably, the acoustical system comprises a plurality of sound output devices, for example two stereo speakers, and the method is performed for every sound output device (or a specified sub set of sound output devices) of the acoustical system.

Preferably, the method comprises the further step of modifying each frequency component of an acoustical signal in response to the frequency response characteristics compensation information for the frequency of said component.

The method according to the invention may be characterised in that the compensation information is the determined impedance for each frequency or is a correction factor for the determined impedance for each frequency.

Output acoustical signals are preferably power-compensated according to their respective frequency components and said compensation information, to thereby compensate for differences in the impedance of said sound output device at different output frequencies.

In a preferred embodiment, the compensation is achieved by adjusting the currents of the signal components.

The invention is further directed to a method of operating a sound device, comprising the steps:

as a first step, calibrating the frequency response characteristics of at least one sound output device of the sound device, by performing the sub-steps:

- Successively applying test signals of a plurality of different effective test frequencies to the sound output device;

- Determining for each test signal applied an impedance of the sound output device;

- Determining, based on the impedance for each test signal, a frequency response characteristics compensation information for each frequency; and

- Storing the frequency response characteristics compensation information for all frequencies into a memory unit;

and as a second step, outputting acoustical signals to the sound output device, while performing a power compensation on frequency components of the input signals, based on the stored frequency response characteristics compensation information, to thereby compensate for differences in the impedance of said sound output device at different output frequencies.

In contrast to the calibration method according to the invention, in this aspect, the method also covers the usual operation of the device after or between the calibration of the compensation.

The method may, as the calibrating step, in particular include the method of performing frequency response characteristics compensation according to the invention.

The invention is in yet another aspect directed to a manufacturing process for sound appliances, which comprise a system according to the invention, and at least one sound output device, which method comprises:

assembling the sound appliance, using said at least one sound output device; and

performing the method of the invention, so that the frequency response characteristics compensation information is stored in the manufactured sound appliance.

Fig. 1 shows a circuit layout depicting the basic components of the device according to the invention;

Fig. 2 shows a more detailed layout of one embodiment of the device according to the invention;

Fig. 3 shows a more detailed layout of another embodiment of the device according to the invention.

Fig. 4 depicts a preferred embodiment of the method according to the invention.

Fig. 5 depicts a further preferred embodiment of the method according to the invention.

The basic principle of the invention resides in the provision of a mechanism which compensates frequency components of an input signal in a way that the different impedances the output device (speaker, headphone) exhibits at these frequencies, are "levelled" or compensated.

Accordingly, the invention is in a first aspect directed to a device for frequency response characteristics compensation of acoustical systems which comprises at least one sound output device; a frequency generator for generating a plurality of test signals of different effective test frequencies to be applied to the sound output device; an impedance measuring device connected to the sound output device for determining the impedance of the sound output device for each of the plurality of test signals applied to the sound output device; a memory unit for storing frequency response characteristics compensation information for each test frequency, in accordance with the impedance determined for the test signal of each test frequency; and a sound processing device for generating acoustical signals to be output to the sound output device, based on input signals, which are power-compensated according to their respective frequency components and said compensation information, to thereby compensate for differences in the impedance of said sound output device at different output frequencies.

A frequency generator is an electronic device capable of generating electrical signals having specific frequencies; in the invention, it is preferred that the frequency generator can generate several signals of different frequencies, covering part of or the entire frequency range that either the sound output device is able to output, or the input signal may have. The term "effective test frequency" refers to the fact that the frequency generator may generate rather diverse signals, including sinus signals, sawtooth signal or complex signals constituted by several basic signals. The effective frequency means the frequency at which these signals act upon the sound output device. According to the invention, the test signal which is used as a signal applied to the sound output device, is one of several test signals used each having a single, determined test frequency.

An input signal is an electrical signal entering the device of the invention through one or several input interfaces, as known to the skilled person in the field of designing audio devices. It represents acoustical information which will be processed by the sound processing device to produce an acoustical signal to be output at the sound output device. The input signal normally consists of numerous different frequency components which together may represent music or speech. According to the invention, the sound processing device processes the input signal's frequency components by applying the frequency response characteristics compensation information to the respective frequency components of the input signal. The processing is performed via e.g. an algorithm implemented in the sound processing device, in order to achieve a power compensation of the signals. Power compensation according to the invention means that the power of the output acoustical signal, when applied to the sound output device, achieves a predetermined absolute or relative value, which is inter alia determined by the impedance of the sound output device at that frequency. Most sound output devices behave like resistors and therefore require to be driven by a changeable, i.e. compensated, current to have a stable power for every frequency, according to the formula:

$$P \ [W] \ = \ U^2 \ [V] \ / \ R \ [\Omega]$$

wherein P is the power in Watts, U is the voltage in Volts, and R is the impedance in Ohms. Also the sound pressure level may be used as a reference for compensating the acoustical signal. In this case, a correlating algorithm must be implemented in order to relate the measured impedance with the sound pressure level. Therefore, an additional measure of the sound pressure characteristics of the sound output device needs to be made. The power may for example be compensated by using a gain coefficient for the signal amplitude.

The processing may further include usual, known processing of the input signal, in order to prepare it for output.

An acoustical signal, as used herein, is an electrical signal capable of being output as sound waves at a sound output device. It may be a signal which needs further amplification, or may directly be output, depending on the type of sound output device. In the present invention, the acoustical signal is the output signal of the sound processing device.

The frequency response characteristics compensation information is some kind of information derived from the frequency of the test signals and the impedances determined for said frequencies, and is or comprises information which is suitable to be used for power compensation of an input signal processed at the sound processing device.

A sound output device is any kind of device which translates electrical signals into audible sound waves.

According to the invention, the device comprises at least one sound output device. It is to be understood however that several sound output devices may be implemented in a device according to the invention, and each of these sound output devices may be compensated individually, based on frequency response characteristics compensation information derived for each sound output device. Accordingly, either several frequency generators, impedance measuring devices, memory units and sound processing devices may be used, or one of these devices, respectively, may be shared among the sound output devices. A typical number of sound output devices will be two for Stereo systems, and five for surround sound systems.

The impedance measuring device according to the invention may be any device for determining an impedance or other values relating to the impedance, like current and/or voltage, of a circuit. Such devices are known in the art. It may be connected in parallel or serially with the sound output device. In a further preferred embodiment, there may additionally be provided a switchable circumventing connection line in order for the acoustical signal to circumvent the impedance measuring device when no impedance measuring is performed (e.g. in normal operating conditions, where an acoustical signal is output at the sound output device).

The memory unit may be any known device/circuit for storing the necessary information, for example a RAM, EPROM, Flash Memory etc. It may also be an analogue device for storing this information. The memory unit may also be part of another device of the inventive device, like a sound processor, a microprocessor, or even the impedance measuring unit.

Preferably, the device according to the invention further comprises an amplifier coupled between the sound processing device and the sound output device for amplifying the acoustical signal.

Preferably, the sound processing device is configured to adjust input signal components of different frequencies having equal input power so as to generate acoustical signals resulting in equal power for the respective frequencies at the sound output device. The power may be the electrical power in the sound output device, or the sound pressure level of the device, etc.

The device may further be characterised in that the frequency generator is connected to the sound processing device, for outputting the test signals to the sound output device via the sound processing device. Alternatively, the frequency generator may also be directly connected with the amplifier or the sound output device.

In a preferred embodiment, the device further comprises a calculating unit connected to the impedance measuring device and to the memory unit, which is used for determining the compensation information according to the measured impedance and a preset algorithm, or/and for calculating the impedance from other values obtained by the impedance measuring device, and for storing said compensation information in the memory unit. The calculating unit may be any device known to the skilled person as being able to perform its task, e.g. a hardware circuit with a built-in algorithm or a programmable device. In its simplest form, the calculating unit may merely be a device for converting the measured impedance values to digital representations thereof, e.g. an A/D converter, and for sending the digital representations to the memory unit, which after having received the digital representations, stores them in memory cells.

As described above, the sound processing device may perform the two tasks of performing a power compensation of the input signal, and of performing further processing known in the art of sound processing, like e.g. filtering, amplitude adjustment or frequency push up/down. In a preferred embodiment of the invention, the sound processing device may comprise a sound processor for performing these tasks of adjusting electrical characteristics of the input signals according to preset rules, and of compensating for differences in the impedance of said sound output device at different output frequencies, according to said compensation information. A sound processor is a device in general well known to skilled persons. E.g. a digital signal processor (DSP) may be used to perform this task. Some sound processors comprise frequency generators. Accordingly, in one preferred embodiment of the invention, the frequency generator may be a part of the sound processor.

In a particular preferred embodiment, the sound processor may also comprise prescale blocks configured for said compensation of the input signals for said differences in the impedance of said sound output device at different output frequencies, according to said compensation information, and common compensation blocks arranged after the prescale blocks configured for adjusting said electrical characteristics of the input signals according to the preset rules. By this embodiments, prescale blocks of the sound processor may be used for compensating the input signals, or special input blocks may be provided in the sound processor for performing this task. Prescale blocks are generally known to skilled persons, but have not been applied for power compensation.

In a further preferred embodiment of the invention, the sound processing device comprises a microprocessor for compensating the input signals for said differences in the impedance of said sound output device at different output frequencies, according to said compensation information, a sound processor for adjusting electrical characteristics of the input signals compensated at the microprocessor, according to preset rules, and a connection between the microprocessor and the sound processor for supplying the input signal to the microprocessor and for supplying the compensated input signals back to the sound processor.

In this embodiment, accordingly, the compensation is not done in the sound processor (if one is provided), but in a general purpose microprocessor, thus removing processing load from the sound processor.

Alternatively, in a further preferred embodiment, the sound processing device may comprise a microprocessor for calculating compensation instructions for compensating differences in the impedance of said sound output device at different output frequencies, according to said compensation information, a connection between the microprocessor and a sound processor and said sound processor for adjusting electrical characteristics of the input acoustical signals according to preset rules, and for compensating said differences in the impedance of said sound output device at different output frequencies, according to said compensation instructions received via the connection. Thus, in this embodiment, an additional microprocessor is used instead of the sound processor itself, to calculate the required power compensation. The result of the calculation is used to control the sound processor, e.g. by sending correction information. In this approach, only part of the compensation of the input signals is performed by a microprocessor, while another part is done by the sound processor.

The microprocessor may at the same time also take the function of the above-mentioned calculating unit which is connected to the impedance measuring device and to the memory unit, for determining said compensation information according to the measured impedance and a preset algorithm, and for storing said compensation information in the memory unit. The memory unit may be part of the microprocessor, or the signal processor, or may be a separate device.

As already outlined above, the sound output device may be any of a number of known devices for generating sound waves. The sound output device may for example comprise a headphone or a speaker or a set of speakers.

The compensation information determined/calculated may take several kinds. For example, the compensation information may simply be the determined impedance for each frequency, or may be a correction factor for the determined impedance for each frequency. Storing the impedances as such requires less calculation when the measurements are performed, but will require more real time calculations when the compensation is done while operating the sound device. Conversely, using a correction factor will require more calculations when the impedance is measured, but may simplify the determination of the compensation to be performed on an input signal in operating the device. The correction factor may e.g. be a factor with which a signal level or voltage etc. of the input signal is to be multiplied by.

The quality of the compensation according to the present invention will inter alia be determined by the number and location in the frequency spectrum of the analysed frequencies. The minimum number of frequencies, for which impedances are determined, will be two. The more frequencies are measured and compensated, the better should be the result of the power compensation; but the more measurements and calculations are required. In one preferred embodiment, the plurality of test signals have equally spaced frequencies. Starting from a "base" frequency, the other test frequencies are determined by adding or subtracting a frequency (Hz amount). Alternatively, the plurality of test signals have predetermined frequencies.

The test signals may take any suitable signal shape. In one preferred embodiment, the test signals are sinoidal signals.

Preferably, there is some kind of synchronisation between the frequency generator and the remaining parts of the measuring system, in order to assure that the impedance measurements are correlated and stored with the right one of the frequencies.

The invention is in another aspect directed to methods. Everything that was said with regard to the device does likewise apply to the methods and vice versa, so that mutual reference is made.

The method according to the invention is for performing frequency response characteristics compensation of acoustical systems, and comprises the steps:

- Successively applying test signals of a plurality of different effective test frequencies to at least one sound output device;

- Determining for each test signal applied an impedance of the sound output device;

- Determining, based on the impedance for each test signal, a frequency response characteristics compensation information for each frequency; and

- storing the frequency response characteristics compensation information for all frequencies; which is to be used by a sound processing device for power compensation of differences in the impedance of said sound output device at different output frequencies, of an acoustical system comprising the sound output device, into a memory unit.

The method is preferably performed when the sound output device is first operated after its manufacturing. This will set the required compensation values for each individual sound output device, in order to compensate individual differences of such devices caused by manufacturing deviations.

In order to account for changes in the frequency response characteristics which may occur over time due to aging effects of the sound output device, the method is in another preferred embodiment performed each time the sound output device is initialised. The method may also be performed periodically or manually.

Preferably, the acoustical system comprises a plurality of sound output devices, for example two stereo speakers, and the method is performed for every sound output device (or a specified sub set of speakers) of the acoustical system.

Preferably, the method comprises the further step of modifying each frequency component of an acoustical signal in response to the frequency response characteristics compensation information for the frequency of said component.

The method according to the invention may be characterised in that the compensation information is the determined impedance for each frequency or is a correction factor for the determined impedance for each frequency.

Output acoustical signals are preferably power-compensated according to their respective frequency components and said compensation information, to thereby compensate for differences in the impedance of said sound output device at different output frequencies.

In a preferred embodiment, the compensation is achieved by adjusting the currents of the signal components.

The invention is further directed to a method of operating a sound device, comprising the steps:

as a first step, calibrating the frequency response characteristics of at least one sound output device of the sound device, by performing the sub-steps:

- Successively applying test signals of a plurality of different effective test frequencies to the sound output device;

- Determining for each test signal applied an impedance of the sound output device;

- Determining, based on the impedance for each test signal, a frequency response characteristics compensation information for each frequency; and

- Storing the frequency response characteristics compensation information for all frequencies into a memory unit;

and as a second step, outputting acoustical signals to the sound output device, while performing a power compensation on frequency components of the acoustical signals, based on the stored frequency response characteristics compensation information, to thereby compensate for differences in the impedance of said sound output device at different output frequencies.

In contrast to the calibration method according to the invention, in this aspect, the method also covers the usual operation of the device after or between the calibration of the compensation.

The method may, as the calibrating step, in particular include the calibration method of the invention.

The invention is furthermore directed to a manufacturing process for sound appliances, which comprise a system according to the invention, and at least one sound output device, which method comprises:

assembling the sound appliance, using said at least one sound output device; and

performing the method of the invention, so that the frequency response characteristics compensation information is stored in the manufactured sound appliance.

This method allows for the "matching" or "pairing" of sound output devices with the controlling electronics, in order to take account of production variance in the manufacture of such sound output devices. Thus, one or several particular sound output devices, like speakers, of some batch of sound output devices are used for assembling one particular sound appliance.

A sound appliance is any device or separate or separable entity used for listening to sound like music or speech.

The present invention relates to a method for power compensation for acoustical systems by using impedance information of the system, thereby establishing high fidelity sound, solving safety problems for the system, providing dynamic speaker compensation, etc. This method can be applicable on every multimedia consumer electronic product which uses a sound output device.

The system realises the impedance & frequency characteristics of the sound output device; stores these characteristics; and uses them in compensation.

The main idea of the invention is processing the audio input signal by reference of the impedance & frequency characteristics of the sound output device.

The speaker impedance is depending on the frequency and the acoustical structure of the sound output device. So, there is a problem to get a stable output power performance for every frequency or a great frequency range with sufficiently small iterations in frequency, in acoustical systems. This causes loss in sound quality and safety problems, etc.

In this application, to get a stable and reliable output power performance in acoustical systems, the impedance & frequency characteristics of the sound output device is determined, stored and used in compensation.

By this method, the frequency response characteristics of the system are idealized; a high fidelity sound is established; current on the sound output device is controlled and safety problem is solved; and dynamic speaker compensation is provided.

In the following, the invention shall be further detailed by providing concrete embodiments of the invention, in which reference is made to the accompanying drawings, in which:

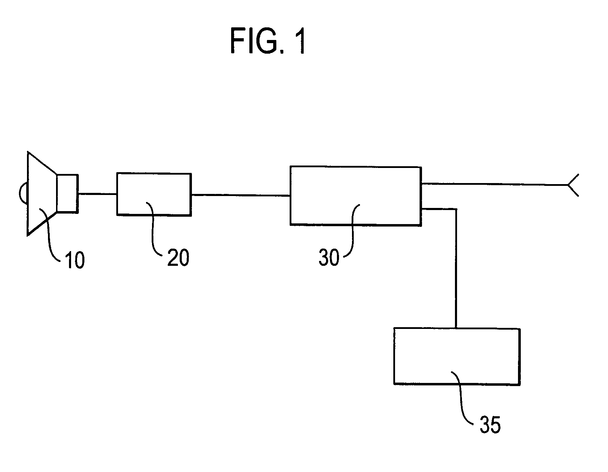

Fig. 1 shows as a basic embodiment the principles of the present invention. A sound output device 10, e.g. a speaker, is connected to an output of a sound processing device 30. The sound processing device 30 has one input at which an input signal representing audio information is input. The input signal may be a digital signal or an analogue signal. The sound processing device 30 has a second input which is in this embodiment connected with a frequency generator 35. It is to be understood that the frequency generator may also be connected at other stages of the sound processing. The device according to the invention further comprises an impedance measuring device 20 for measuring the impedance of the sound output device 10 when a signal of a particular frequency is generated by the frequency generator 35. The impedance measurement may be further processed in order to derive frequency response characteristics compensation information, or may directly be used as such information. The compensation information is stored in a memory unit (not shown) which may e.g. be part of the impedance measuring device 20 or the sound processing device 30. Additionally, control connection may be provided between the units shown in Fig. 1, in order to control which frequency is generated, and to assure that the impedance is associated with the proper frequency. A coordinated action of frequency generator 35 and impedance measuring unit 20 may however also be achieved with a time synchronised action of the two units, provided that they are sufficiently time synchronisable.

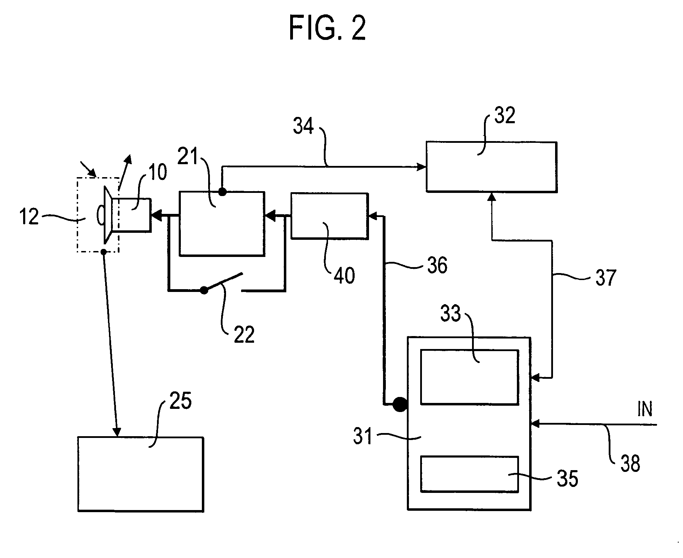

The system of the embodiment shown in Fig. 2 consists of six main blocks. These are; an impedance sensor 21, microprocessor 32, signal generator (frequency generator) 35, sound processor 31, coefficient table (memory unit) 33 of the algorithm and changeable total system impedance shown at 25. The sound output system 20 consists of a chassis 12 and the speaker 11 itself. Furthermore, an amplifier 40 is provided.

Additionally, the device according to this embodiment includes a impedance line for connecting the impedance sensor 21 with the microprocessor 32, a gain feedback line 37 for connecting the microprocessor 32 with the sound processor 31, an input line 38 for supplying the sound processor 31 with input signals, and an audio line 36 for transferring the processed acoustical signal from sound processor 31 to the amplifier 40. A by-pass including a switch 22 is used to by-pass or circumvent the impedance sensor 21 when no impedance measurements are to be performed.

The frequency generator 35 is responsible for generating (audio) test signals that are used to determine the impedance & frequency characteristics of the system and should be activated at least in installation and when the sound output device 10 of the system is changed. The frequency of the generated signal and the impedance of the sound output device 10 in that frequency are stored in the coefficient table 33 as the impedance & frequency characteristics data of the system.

The frequency generator 35 can be included in the sound processor 31 or the microprocessor 32.

The system determines the frequency response characteristics only if that frequency is generated by the generator.

Some sound processors 31 include frequency generators 35. In those systems there is no use for having an outer generator block in the system.

The impedance sensor device 21 determines the characteristic data that can be voltage, current or impedance for that frequency and sends it to the coefficient table of the algorithm. Current prop, low power consuming ohmic resistance, magnetic field sensor or any electronic component that is capable of determining current or voltage or impedance can be used as impedance sensor. As different sensors have different properties, it may be in series or parallel to the system. The appropriate impedance sensor for every system may vary.

Also the impedance sensor may be by-passed if there will be no change in the impedance & frequency characteristics of the sound output device.

The frequency of the generated signal and the frequency response of the system for that frequency are stored in the coefficient table of the algorithm 33.

The coefficient table consists of - full scale (if possible) - impedance & frequency coefficients and any coefficient related to frequency response in order to base frequency impedance response of the system.

The frequency values in the coefficient table 33 can changed if another signal generator 35 is used to determine the frequency response of the sound output device 10. Also, the frequency response of the sound output device 10 can change if another signal generator 35 is used to determine the frequency response.

The following table is an example for a coefficient table usable with the present invention.

**Coefficient Table**

| Frequency | 100 Hz | 200 Hz | 500 Hz | 800 Hz | 1 KHz | 3 KHz | 5 Khz | 7 KHz | 15 KHz |
|---|---|---|---|---|---|---|---|---|---|

(continued)

| Impedance | 9Ω | 8Ω | 7Ω | 6Ω | 8Ω | 10Ω | 11Ω | 12Ω | 16Ω |
|---|---|---|---|---|---|---|---|---|---|
| **Gain Coefficient** | ** | ** | ** | >> Amplitude **Gain 0,86** 7,7v | $P=U^2/R$ >> Amplitude **Gain 1** 8,9v | >> Amplitude **Gain 1,2** 10v | ** | ** | ** |

Any read/write memory device can be used to store the coefficient table. Also, memory device can be a separate memory device or be included by micro controller or sound processor.

The microprocessor 32 is responsible for sound processing for compensation. The microprocessor gets the impedance & frequency characteristics data of the system from the coefficient table 33 and compensates the input audio signal.

That compensation includes any sound processing including filtering, amplitude adjustment or frequency push up / down.

The main idea of the compensation is signal processing before the common blocks of sound processing. Sound processing before the common sound processing blocks has lots of advantages like lower noise ratio and power reduction. The sound processing for compensation can be done in the microprocessor or prescale blocks of the sound processor. By this method, the disadvantages of the common equalization are avoided.

As the power at the output is granted to be stable, the performance of the sound output device is maximized, the current on the output device can be controlled, most of the reasons of sound quality loss like Doppler effect at the output signal is avoided.

The microprocessor 32 may be included by the sound processor 31 to form a complete sound processing device 30.

The sound processor 31 is responsible for frequency analysis of the audio input signal by referencing the data in the coefficient table 33. The analysed signal is compensated in the microprocessor 32.

The changeable total system impedance can be simulated as a circuit 25. That block is used to have a reference value for the impedance & frequency response characteristics of the sound output device.

Gain feedback line 37 and audio line 36 can be moved into the sound processor 31 if related blocks can be included by the sound processor 31.

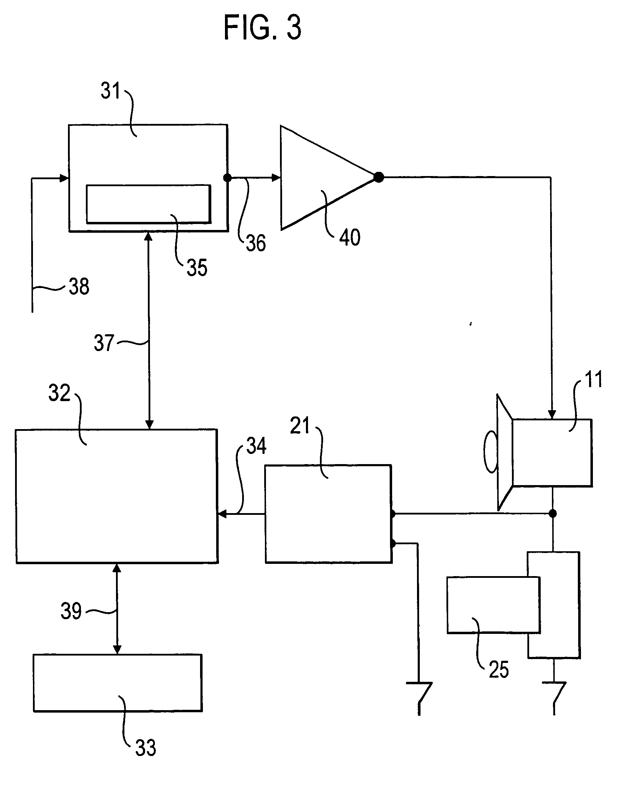

Fig. 3 shows a further embodiment of the present invention. Like reference numerals are used to indicate like features as in Figs. 1 and 2.

The diagram of Fig. 3 illustrates the general circuit diagram a further embodiment of the invention including the main components.

In this embodiment, signals generated by generator 35 which can be a separate component or be included in microprocessor 32 or sound processor 31 is used to determine the frequency response of the system at that frequency. Impedance response characteristics are stored in the coefficient table 33 shown as a separate device in this embodiment. The data in the coefficient table include impedance coefficients for every frequency that can be generated and other compensation coefficients that can be determined or calculated by the inventive device and method. Stored data is used to compensate the unprocessed audio input signal in the microprocessor. The compensated audio input signal can be processed in sound processor and is directed to the amplifier. The compensated, processed and amplified audio signal is received by the sound output device 11.

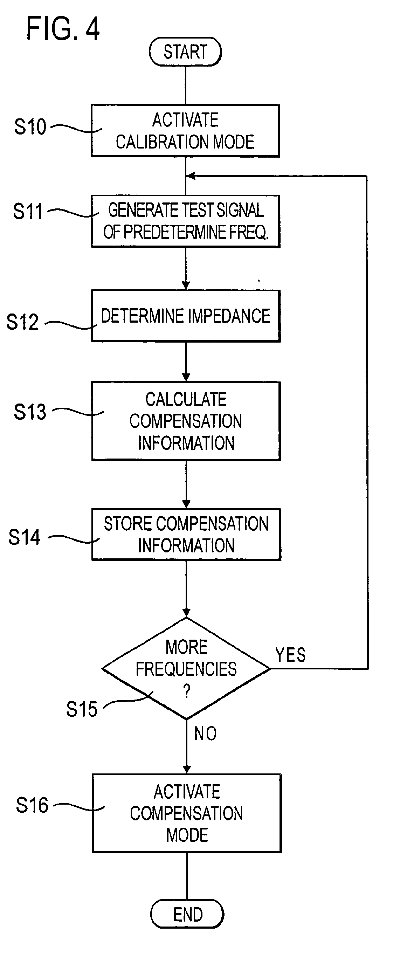

Fig. 4 depicts a preferred embodiment of the method according to the invention. In particular, the part of the method in which the compensation information is determined and stored is shown. In method step S10, a calibration mode of the device is activated. This may comprise switching on the impedance measuring device 21, activating and setting the frequency generator, loading a program for analysing the measured impedance/voltage/current values into a microprocessor, etc. In step S11, a test signal of a specified, predetermined frequency is generated and output/applied to the sound output device 10, by the frequency generator 35. In step S12, the impedance is determined for the applied frequencies by the impedance measuring device 21, possibly in connection with a calculating unit. In step S13, a compensation information for said frequency is calculated, based on some preset algorithm, and the impedance determined in step S12. This compensation information is stored in step S14 in a memory unit, together with some reference to the frequency which is presently assessed. After this, it is judged in step S15 if more frequencies are to be tested. If this is the case, the processing returns to step S11. If no more impedances of further frequencies need to be determined, and the calibration is hence completed, the processing proceeds to step S16, in which a "compensation" or normal operating mode is activated, while the calibration mode is terminated.

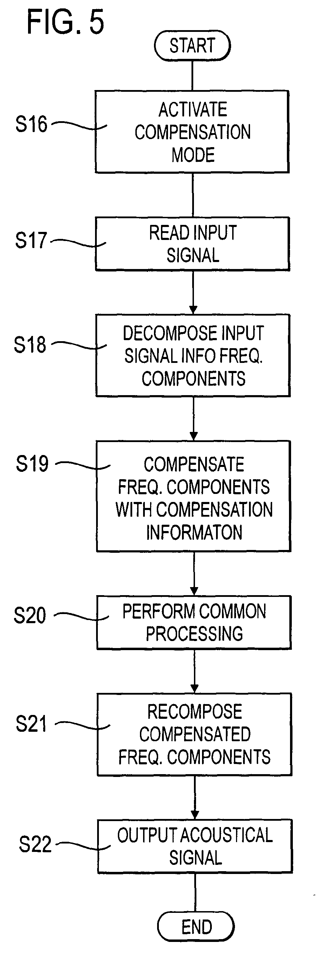

Fig. 5 depicts a further preferred embodiment of the method according to the invention. In particular, the "compensation" mode mentioned in Fig. 5 is shown, which uses the compensation information obtained in the process outlined in e.g. Fig. 4. Therein, in step S16 (identical to step 16 of Fig. 4), the compensation mode is activated. In step S17, an input signal representing some kind of acoustical information is read into the sound processing device. In step S18, the input signal is decomposed into frequency components, to which a compensation is to be applied. It is to be understood that other approaches for compensation may be used, as long as a frequency specific compensation for differences in the impedance is possible with the respective frequency components of the input signal. In step S19, the compensation itself is performed on the frequency components of the input signal, using e.g. a sound processor, a microprocessor, some suitable algorithm and the compensation information. This results in compensated input signal frequency components, which may optionally be further processed in known manner to improve the signal, in step S20. In step S21, the compensated frequency components are recomposed, in order to give a compensated output acoustical signal. If a digital input signal is used, a digital/analogue conversion must additionally be performed at some step of the method, preferably after the compensation is done.

The present invention has obvious advantages in acoustical compensation as the compensation is achieved by using determined and stored impedance & frequency characteristics of the system in a separate microprocessor or in prescale block of a sound processor before the common compensation blocks. These advantages include: high fidelity sound at the output, a solution for safety problems, power reduction in sound processing and stability in output power.

**Claims**

1.    Device for frequency response characteristics compensation of acoustical systems, comprising:

at least one sound output device (10);
a frequency generator (35) for generating a plurality of test signals of different effective test frequencies to be applied to the sound output device (10);
an impedance measuring device (20) connected to the sound output device (10) for determining the impedance of the sound output device (10) for each of the plurality of test signals applied to the sound output device (10);
a memory unit (33) for storing frequency response characteristics compensation information for each test frequency, in accordance with the impedance determined for the test signal of each test frequency; and
a sound processing device (30) for generating acoustical signals to be output to the sound output device (10), based on input signals, which are power-compensated according to their respective frequency components and said compensation information, to thereby compensate for differences in the impedance of said sound output device (10) at different output frequencies.

2.    Device according to claim 1, further comprising an amplifier coupled between the sound processing device (30) and the sound output device (10) for amplifying the acoustical signal.

3.    Device according to claim 1 or 2, **characterised in that** the sound processing device (30) is configured to adjust input signal components of different frequencies having equal input power so as to generate acoustical signals resulting in equal power for the respective frequencies at the sound output system.

4.    Device according to any of claims 1 to 4, further comprising a calculating unit (22) connected to the impedance measuring device (20) and to the memory unit (33), for determining said compensation information according to the measured impedance and a preset algorithm, and storing said compensation information in the memory unit (33).

5.    Device according to any of claims 1 to 5, **characterised in that** the sound processing device (30) comprises a sound processor (31) for adjusting electrical characteristics of the input signals according to preset rules, and for compensating for differences in the impedance of said sound output device (10) at different output frequencies, according to said compensation information.

6.    Device according to claim 5, **characterised in that** the sound processor comprises prescale blocks configured for said compensation of the input signals for said differences in the impedance of said sound output device (10) at different output frequencies, according to said compensation information, and common compensation blocks arranged after the prescale blocks configured for adjusting said electrical characteristics of the input signals according to the preset rules.

7.    Device according to any of claims 1 to 5, **characterised in that** the sound processing device (30) comprises a microprocessor (32) for compensating the input signals for said differences in the impedance of said sound output device (10) at different output frequencies, according to said compensation information,
a sound processor (31) for adjusting electrical characteristics of the input signals compensated at the microprocessor, according to preset rules, and
a connection (37) between the microprocessor (32) and the sound processor (31) for supplying the input signal to the microprocessor (32) and for supplying the compensated input signals back to the sound processor.

8. Device according to any of claims 1 to 5, **characterised in that** the sound processing device (30) comprises a microprocessor (32) for calculating compensation instructions for compensating for differences in the impedance of said sound output device (10) at different output frequencies, according to said compensation information,
a connection (37) between the microprocessor (32) and a sound processor (31),
said sound processor (31) for adjusting electrical characteristics of the input acoustical signals according to preset rules, and for compensating said differences in the impedance of said sound output device (10) at different output frequencies, according to said compensation instructions received via the connection (37).

9. Device according to claim 7 or 8, **characterised in that** said microprocessor (32) is also a calculating unit (32) connected to the impedance measuring device (20) and to the memory unit (33), for determining said compensation information according to the measured impedance and a preset algorithm, and storing said compensation information in the memory unit (33).

10. Device according to any of claims 1 to 9, **characterised in that** the sound output device (10) comprises a headphone or a speaker (11) or a set of speakers.

11. Device according to any of claims 1 to 10, **characterised in that** the compensation information is the determined impedance for each frequency.

12. Device according to any of claims 1 to 10, **characterised in that** the compensation information is a correction factor for the determined impedance for each frequency.

13. Device according to any of claims 1 to 12, **characterised in that** the plurality of test signals have equally spaced frequencies.

14. Device according to any of claims 1 to 12, **characterised in that** the plurality of test signals have predetermined frequencies.

15. Device according to any of claims 1 to 14, **characterised in that** the test signals are sinoidal signals.

16. Method for performing frequency response characteristics compensation of acoustical systems, comprising the steps:

 - Successively applying (S11) test signals of a plurality of different effective test frequencies to at least one sound output device (10);
 - Determining (S12) for each test signal applied an impedance of the sound output device (10);
 - Determining (S13), based on the impedance for each test signal, a frequency response characteristics compensation information for each frequency; and
 - storing (S14) the frequency response characteristics compensation information for all frequencies; which is to be used by a sound processing device (30) for power compensation of differences in the impedance of said sound output device (10) at different output frequencies, of an acoustical system comprising the sound output device (10), into a memory unit (33) .

17. Method according to claim 16, **characterised in that** said method is performed when the sound output device (10) is first operated after its manufacturing.

18. Method according to claim 16 or 17, **characterised in that** said method is performed each time the sound output device (10) is initialised.

19. Method according to any of claims 16 to 18, **characterised in that** said method is performed periodically or manually.

20. Method according to any of claims 16 to 19, **characterised in that** the acoustical system comprises a plurality of sound output devices (10) and the method is performed for every sound output device (10) of the acoustical system.

**21.** Method according to any of claims 16 to 20, comprising the further step of modifying (S19) each frequency component of an input signal in response to the frequency response characteristics compensation information for the frequency of said component.

**22.** Method according to any of claims 16 to 21, **characterised in that** the compensation information is the determined impedance for each frequency.

**23.** Method according to any of claims 16 to 21, **characterised in that** the compensation information is a correction factor for the determined impedance for each frequency.

**24.** Method according to any of claims 21 to 23, in which output acoustical signals are power-compensated (S19) according to their respective frequency components and said compensation information, to thereby compensate for differences in the impedance of said sound output device (10) at different output frequencies.

**25.** Method according to any of claims 21 to 24, **characterised in that** the compensation is achieved by adjusting the currents of the signal components.

**26.** Method of operating a sound device, comprising the steps:

as a first step, calibrating the frequency response characteristics of at least one sound output device (10) of the sound device, by performing the sub-steps:

- Successively applying (S11) test signals of a plurality of different effective test frequencies to the sound output device (10);
- Determining (S12) for each test signal applied an impedance of the sound output device (10);
- Determining (S13), based on the impedance for each test signal, a frequency response characteristics compensation information for each frequency; and
- Storing (S14) the frequency response characteristics compensation information for all frequencies into a memory unit (33);

and as a second step, outputting (S22) acoustical signals to the sound output device (10), while performing (S19) a power compensation on frequency components of the input signals, based on the stored frequency response characteristics compensation information, to thereby compensate for differences in the impedance of said sound output device (10) at different output frequencies.

**27.** Method according to claim 26, **characterised by** performing, as a calibrating step, the method of any of claims 15 to 18.

**28.** Manufacturing process for sound appliances, which comprise a system according to any of claims 1 to 15, and at least one sound output device (10), comprising:

assembling the sound appliance, using said at least one sound output device (10); and performing the method of claims 16 to 25, so that the frequency response characteristics compensation information is stored in the manufactured sound appliance.

**29.** Device according to any of claims 1 to 3, **characterised in that** the frequency generator is connected to the sound processing device (30), for outputting the test signals to the sound output device (10) via the sound processing device (30).

# FIG. 1

# FIG. 2

# FIG. 3

# FIG. 4

START

S10 — ACTIVATE CALIBRATION MODE

S11 — GENERATE TEST SIGNAL OF PREDETERMINE FREQ.

S12 — DETERMINE IMPEDANCE

S13 — CALCULATE COMPENSATION INFORMATION

S14 — STORE COMPENSATION INFORMATION

S15 — MORE FREQUENCIES ? — YES

NO

S16 — ACTIVATE COMPENSATION MODE

END

# FIG. 5

START

S16 — ACTIVATE
COMPENSATION
MODE

S17 — READ INPUT
SIGNAL

S18 — DECOMPOSE INPUT
SIGNAL INFO FREQ.
COMPONENTS

S19 — COMPENSATE
FREQ. COMPONENTS
WITH COMPENSATION
INFORMATON

S20 — PERFORM COMMON
PROCESSING

S21 — RECOMPOSE
COMPENSATED
FREQ. COMPONENTS

S22 — OUTPUT ACOUSTICAL
SIGNAL

END

**EP 1 887 687 A1**

<table>
<tr><td colspan="2">European Patent<br>Office</td><td>EUROPEAN SEARCH REPORT</td><td>Application Number<br>EP 06 01 6049</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/017921 A1 (MANTOVANI JOSE RICARDO BADDINI [US]) 29 January 2004 (2004-01-29) * the whole document * ----- | 1-29 | INV. H03G5/24 H04R3/04 |
| X | JP 61 019297 A (MATSUSHITA ELECTRIC IND CO LTD) 28 January 1986 (1986-01-28) * abstract; figures 3-5 * ----- | 1-3, 10-12, 14-24, 26-28 | |
| A | JP 60 254899 A (MATSUSHITA ELECTRIC IND CO LTD) 16 December 1985 (1985-12-16) * abstract; figures 1-4 * ----- | 1-29 | |
| A | US 2006/093159 A1 (KOH YOU-KYUNG [KR] ET AL) 4 May 2006 (2006-05-04) * abstract; figures 3,6 * * paragraphs [0010], [0021], [0024], [0029] - [0032] * ----- | 1-29 | TECHNICAL FIELDS SEARCHED (IPC) H03G H04R |

The present search report has been drawn up for all claims

| Place of search | Date of completion of the search | Examiner |
|---|---|---|
| Munich | 26 January 2007 | Wichert, Beate |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 01 6049

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2007

| Patent document cited in search report | | | Publication date | Patent family member(s) | | | Publication date |
|---|---|---|---|---|---|---|---|
| US 2004017921 | A1 | | 29-01-2004 | AU | 2003256688 | A1 | 16-02-2004 |
| | | | | BR | 0312974 | A | 14-06-2005 |
| | | | | CN | 1682441 | A | 12-10-2005 |
| | | | | EP | 1552608 | A2 | 13-07-2005 |
| | | | | KR | 20050026967 | A | 16-03-2005 |
| | | | | WO | 2004012476 | A2 | 05-02-2004 |
| JP 61019297 | A | | 28-01-1986 | NONE | | | |
| JP 60254899 | A | | 16-12-1985 | JP | 1986295 | C | 08-11-1995 |
| | | | | JP | 7022438 | B | 08-03-1995 |
| US 2006093159 | A1 | | 04-05-2006 | KR | 20060039117 | A | 08-05-2006 |
| | | | | NL | 1030038 | A1 | 03-05-2006 |

EPO FORM P0459

For more details about this annex : see Official Journal of the European Patent Office, No. 12/82